# EUROPÄISCHE PATENTSCHRIFT

(11) **EP 1 090 305 B1**
(45) Veröffentlichungstag und Bekanntmachung des Hinweises auf die Patenterteilung: **27.03.2002**
(21) Anmeldenummer: 99936431.8
(22) Anmeldetag: 02.06.1999
(51) Int. Cl.: G01R 31/40, H02J 7/35

(54) **VORRICHTUNG ZUM ÜBERPRÜFEN VON AUTONOMEN SOLARANLAGEN**
DEVICE FOR TESTING SOLAR HOME SYSTEMS
DISPOSITIF POUR LE CONTROLE D'INSTALLATIONS SOLAIRES AUTONOMES

(30) Priorität: 26.06.1998 DE 19828560
(43) Veröffentlichungstag der Anmeldung: 11.04.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: PREISER, Klaus, D-79238 Ehrenkirchen (DE); KUHMANN, Jérôme, D-79271 St. Peter (DE)
(74) Vertreter: RACKETTE Partnerschaft Patentanwälte
(86) Internationale Anmeldenummer: DE9901682
(87) Internationale Veröffentlichungsnummer: WO0000839

(56) Entgegenhaltungen:
- US-A- 4 888 702
- PATENT ABSTRACTS OF JAPAN vol. 1997, no. 02, 28. Februar 1997 (1997-02-28) & JP 08 278354 A (SHIKOKU SOGO KENKYUSHO:KK), 22. Oktober 1996 (1996-10-22)

## Beschreibung

Die Erfindung betrifft eine Vorrichtung zum Überprüfen von autonomen Solaranlagen, die als Komponenten wenigstens jeweils einen photovoltaischen Solargenerator, eine Batterie, einen Laderegler und eine Last umfassen.

Autonome Solaranlagen wie zum Beispiel sogenannte Solare Home Systeme, abgekürzt SHS, dienen der autonomen, von Stromnetzen unabhängigen Versorgung insbesondere häuslicher Bereiche mit verhältnismäßig niedrigem Stromverbrauch. Sie sind üblicherweise aus wenigstens einem photovoltaischen Solargenerator, einer Batterie, einem Laderegler sowie einer aus beispielsweise mehreren Verbrauchem zusammengesetzten Last aufgebaut, die miteinander verschaltet sind. Um eine ordnungsgemäße Funktionsweise derartiger, für die Eigentümer häufig existenznotwendigen Solaranlagen sicherzustellen, müssen die einzelnen Komponenten regelmäßig überprüft werden, um drohende Funktionsausfälle der gesamten Solaranlage frühzeitig erkennen zu können. Diese Überprüfung erfolgte bislang dadurch, daß die einzelnen Komponenten der Solaranlage voneinander entkoppelt werden und mit einer batterieversorgten Spannungsquelle, einem Voltmeter, einem Widerstandmesser, einer Stromzange und einem Säuredichtemesser sehr aufwendig überprüft werden. Für eine ordnungsgemäße Überprüfung jedoch ist hierbei qualifiziertes technisches Personal notwendig, da nicht nur verhältnismäßig komplizierte Meßvorgänge an den einzelnen Komponenten durchgeführt werden müssen, sondern auch, um die Solaranlage nach Durchführen der Einzeltests wieder in einen funktionsfähigen Zustand zu verschalten. Dabei ist eine Überprüfung der Solaranlage nach der erneuten Verschaltung der einzelnen Komponenten in einen betriebsfähigen Zustand ist nicht möglich. Insbesondere in Entwicklungsländern ist dies jedoch ein nicht unerhebliches Problem bei der Planung und Aufrechterhaltung einer dezentralen Strornversorgung.

US-A-4,888,702 offenbart eine Vorrichtung zum Überprüfen von autonomen Solaranlagen, die als Komponenten wenigstens jeweils einen photovoltaischen Solargenerator, eine Batterie, einen Laderregler und eine Last umfassen. Die Vorrichtung umfaßt einen Mikroprozessor, mit dem verschiedene Systemparameter darstellbar und Kontrollfunktionen durchführbar sind. Zur Ausführung der Kontrollfunktionen ist der Mikroprozessor mit einer Anzahl von in einer Speichereinheit abgelegten Einstellwerten ausgestattet, die bestimmten Systemparametern entsprechen und als Referenzwerte bei der Durchführung der Kontrollfunktionen dienen. Die Einstellwerte sind durch Wechsel der Speichereinheit variabel, um einen großen Bereich von Parametern abzudecken.

Patent Abstracts of Japan, Band 1997, Nr. 02, 28. Februar 1997 (1997-02-28) & JP 08 278354 A offenbaren eine Vorrichtung zur Überprüfung einer Solarbatterie, bei der Betriebsparameter einer Standardsolarzelle auf spezifische Umgebungsbedingungen umgerechnet und mit entsprechenden Betriebsparametern der zu überprüfenden Solarzelle in den betreffenden Umgebungsbedingungen verglichen werden, um Defekte feststellen.

Der Erfindung liegt die Aufgabe zugrunde, eine Vorrichtung zum Überprüfen von autonomen Solaranlagen, die als Komponenten wenigstens jeweils einen photovoltaischen Solargenerator, eine Batterie, einen Laderegler und eine Last umfassen, anzugeben, die eine einfache, schnelle und dennoch zuverlässige Überprüfung derartiger Solaranlagen auch durch weniger qualifiziertes technisches Personal zuläßt.

Diese Aufgabe wird bei einer Vorrichtung der eingangs genannten Art erfindungsgemäß gelöst mit Anschlußmitteln zum Anschluß an den von den übrigen Komponenten abgekoppelten Laderegler, mit Anschlußmitteln zum Anschluß an den oder jeden Solargenerator, die oder jede Batterie sowie die oder jede Last bei abgekoppeltem Laderegler beziehungsweise abgekoppelten Ladereglern, mit Prüfmitteln, mit denen die Komponenten einzeln und in betriebstypischen Verschaltungen untereinander zum Ermitteln von für die Funktionsfähigkeit der zu überprüfenden Solaranlage charakteristischen Kenngrößen und Zustände überprüfbar sind, und mit Anzeigemitteln zum Anzeigen der überprüften Kenngrößen und Zustände, wobei die Anschlußmittel Steckerleisten umfassen, die in zugeordnete Buchsenleisten einer mit einer Brücke unterbrechbaren Anschlußschiene für die Komponenten einfügbar sind.

Dadurch, daß die erfindungsgemäße Vorrichtung mit Anschlußmitteln zum einen an den oder jeden abgekoppelten Laderegler sowie zum anderen an die übrigen Komponenten einer zu überprüfenden Solaranlage wie ein netzunabhängiges, photovoltaisch versorgtes Gleichspannungssystem anschließbar ist und mit Prüfmitteln die Komponenten einzeln sowie in betriebstypischen Verschaltungen untereinander überprüfbar sind, läßt sich eine Solaranlage ohne aufwendige Umbauten beispiels weise mit einer als Handtestgerät mit Testleitungsbäumen und Teststeckern ausgebildeten Vorrichtung automatisiert ohne händischen Eingriff auch durch weniger qualifiziertes Personal überprüfen.

Für einen wartungsfreien Betrieb der erfindungsgemäßen Vorrichtung ist zweckmäßigerweise vorgesehen, daß die Prüfmittel und Anzeigemittel über Spannungswandler zur externen Energieversorgung an wenigstens eine Batterie der zu überprüfenden Solaranlage anschließbar sind, so daß Probleme mit einer internen Energieversorgung wie Verfügbarkeit von Batterien auch in abgelegenen Gebieten mit einer schlechten Infrastruktur vermieden sind.

Für eine sehr exakte Überprüfung von Schaltschwellen des oder jedes Ladereglers ist es vorteilhaft, daß die Prüfmittel eine einstellbare Referenzspannungsquelle umfassen.

In Ausgestaltungen der erfindungsgemäßen Vorrichtung sind verschiedene Testmodi durchführbar.

In einer Einstellung der Prüfmittel und Anzeigemittel ist ein Selbsttest zum Überprüfen der ordnungsgemäßen Funktion durchführbar, bei dem die Funktionsfähigkeit von Ansteuermitteln und Schaltmitteln überprüfbar ist.

In einer weiteren Einstellung der Prüfmittel und Anzeigemittel ist ein Solargeneratortest durchführbar, bei dem die Leerlaufspannung und der Kurzschlußstrom des oder jedes Solargenerators bei von dem oder jedem Laderegler abgekoppelten Komponenten Batterie beziehungsweise Batterien und Last beziehungsweise Lasten meßbar ist.

In einer weiteren Einstellung der Prüfmittel und Anzeigemittel ist ein Batterietest der Batterie beziehungsweise Batterien durchführbar, bei dem die Leerlaufspannung, die Spannung bei zugeschalteter Last beziehungsweise Lasten sowie zugeschaltetem Solargenerator beziehungsweise zugeschalteten Solargeneratoren und der Ladestrom bei abgekoppelter Last beziehungsweise abgekoppelten Lasten meßbar ist.

Bei dem Solargeneratortest und dem Batterietest ist es zweckmäßig, daß die Prüfmittel einen Referenzsolargenerator zur Ermittlung der Sonneneinstrahlung umfassen.

In einer weiteren Einstellung der Prüfmittel und Anzeigemittel ist ein Lasttest durchführbar, bei dem die Spannung und der Strom der oder jeder Last sowie die Spannung der oder jeder Batterie bei abgekoppelten Solargenerator beziehungsweise abgekoppelten Solargeneratoren meßbar ist.

Bei den Ausgestaltungen zum Durchführen der Tests ist es bei dem Vorsehen der einstellbaren Referenzspannungsquelle vorteilhaft, daß in einer Einstellung der Prüfmittel und Anzeigemittel zum Durchführen eines Ladereglertests bei abgekoppelten Komponenten Solargenerator beziehungsweise Solargeneratoren, Batterie beziehungsweise Batterien sowie Last beziehungsweise Lasten die einstellbare Referenzspannungsquelle auf den oder jeden Laderegler schaltbar ist und der Eigenverbrauch sowie Schaltschwellen des beziehungsweise jedes Ladereglers überprüfbar sind.

Für den Ladereglertest weisen die Prüfmittel zweckmäßigerweise einen Temperatursensor zur Ermittlung der Umgebungstemperatur auf.

Weitere zweckmäßige Ausgestaltungen sind Gegenstand der Unteransprüche sowie der nachfolgenden Beschreibung eines Ausführungsbeispiels der Erfindung mit Bezug auf die Figuren der Zeichnung. Es zeigen:
- Fig. 1: in einer anschaulichen perspektivischen Darstellung eine ein Handtestgerät aufweisende Vorrichtung zum Überprüfen von autonomen Solaranlagen, die zusammen mit weiteren Komponenten der Solaranlage an eine Anschlußschiene angeschlossen ist,
- Fig. 2: in einer perspektivischen Ansicht die Vorrichtung gemäß Fig. 1,
- Fig. 3 und Fig. 4: den funktionalen Aufbau der Anordnung gemäß Fig. 1, der zu Erläuterungszwecken anhand von exemplarischen Schaltbildern erläutert wird,
- Fig. 5: in einem Funktionsschaltbild eine Selbsttesteinheit des Handtestgeräts gemäß Fig. 3 sowie Fig. 4,
- Fig. 6: in einem Funktionsschaltbild den Aufbau einer Steuereinheit des Handtestgeräts gemäß Fig. 3 sowie Fig. 4 und
- Fig. 7: in einem Funktionsschaltbild den Aufbau einer Ladereglertesteinheit des Handtestgeräts gemäß Fig. 3 sowie Fig. 4.

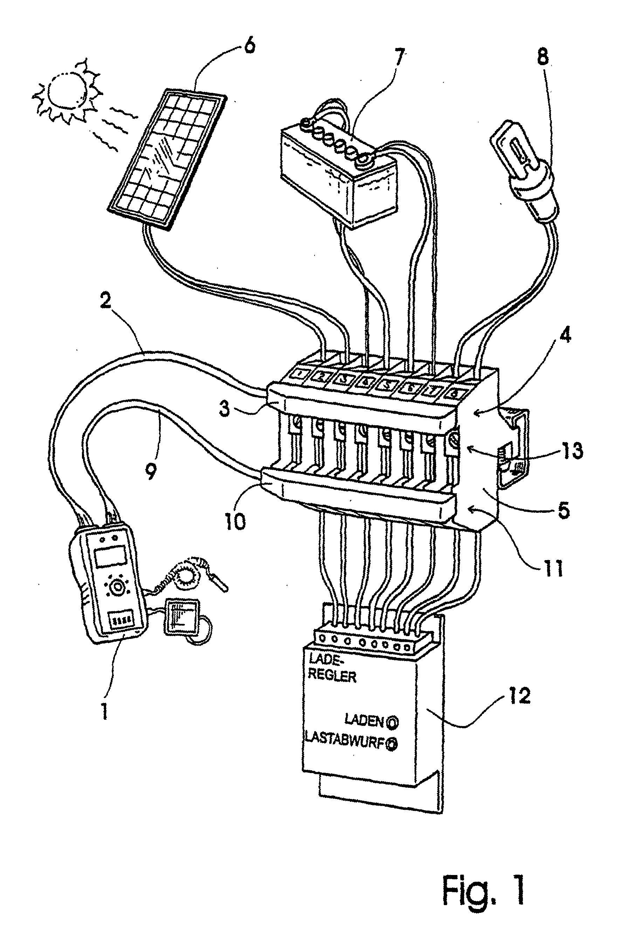

Fig. 1 zeigt in einer anschaulichen perspektivischen Darstellung ein ein Handtestgerät 1 mit Prüfmitteln und Anzeigemitteln umfassendes Ausführungsbeispiel einer erfindungsgemäßen Vorrichtung zum Überprüfen von autonomen Solaranlagen in der Gestalt von netzunabhängigen, photovoltaisch versorgten Gleichspannungssystemen. Die Vorrichtung gemäß Fig. 1 weist einen ersten Testleitungsbaum 2 und einen an den ersten Testleitungsbaum angeschlossenen ersten Teststecker 3 von Anschlußmitteln auf, die bei Einstecken des ersten Teststeckers 3 in eine erste Buchsenleiste 4 einer Anschlußschiene 5 mit einem Solargenerator 6, einer Batterie 7 sowie einer Last 8 als Komponenten einer zu überprüfenden Solaranlage in Verbindung steht. Weiterhin weist die Vorrichtung gemäß Fig. 1 einen zweiten Testleitungsbaum 9 sowie einen zweiten Teststecker 10 von Anschlußmitteln auf, die bei Einstecken des zweiten Teststeckers 10 in eine zweiten Buchsenleiste 11 der Anschlußschiene 5 mit einem Laderegler 12 als weiterer Komponente der zu überprüfenden Solaranlage in Verbindung steht. Die Anschlußschiene 5 ist weiterhin mit einer Brücke 13 ausgebildet, die den Solargenerator 6, die Batterie 7 sowie die Last 8 einerseits mit dem Laderegler 12 andererseits verbindet. Nach Entfernen der Brücke 13 von der Anschlußschiene 5 und Einfügen der Teststecker 3, 10 in die zugehörigen Buchsenleisten 4, 11 ist das Handtestgerät 1 zwischen den Solargenerator 6, die Batterie 7, die Last 8 sowie den Laderegler 12 geschaltet.

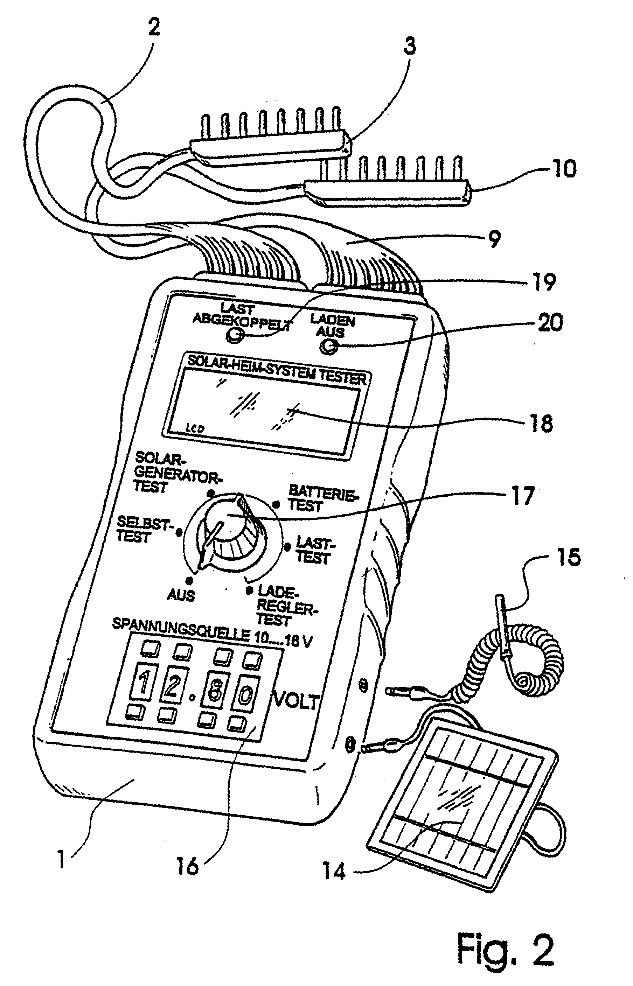

Fig. 2 zeigt in einer perspektivischen Darstellung insbesondere das Handtestgerät 1 der Vorrichtung gemäß Fig. 1 mit den angeschlossenen Testleitungsbäumen 2, 9 und Teststeckern 3, 10. An das Handtestgerät 1 sind ein Referenzsolargenerator 14 sowie ein Temperatursensor 15 von Prüfmitteln der beispielhaft dargestellten erfindungsgemäßen Vorrichtung anschließbar. Das Handtestgerät 1 weist eine Spannungseingabeeinheit 16 auf, mit der auf wenigstens 100 Millivolt, vorzugsweise auf wenigstens 10 Millivolt genau eine Referenzspannung einstellbar ist. Das Handtestgerät 1 ist weiterhin mit einer in dem dargestellten Ausführungsbeispiel als mehrstufiger Drehschalter ausgebildeten Testwahlschalteinheit 17 ausgestattet, über die der Solargenerator 6, die Batterie 7; die Last 8 und der Laderegler 12 einzeln und in betriebstypischen Verschaltungen untereinander zum Ermitteln von für die Funktionsfähigkeit der zu überprüfenden Solaranlage charakteristischen Kenngrößen und Zuständen überprüfbar sind. In das Handtestgerät 1 der beispielhaft dargestellten erfindungsgemäßen Vorrichtung integrierte Anzeigemittel umfassen eine mehrzeilige Flüssigkristallanzeige 18 sowie eine Tiefentladeschutzanzeige 19 und eine Überladeschutzanzeige 20.

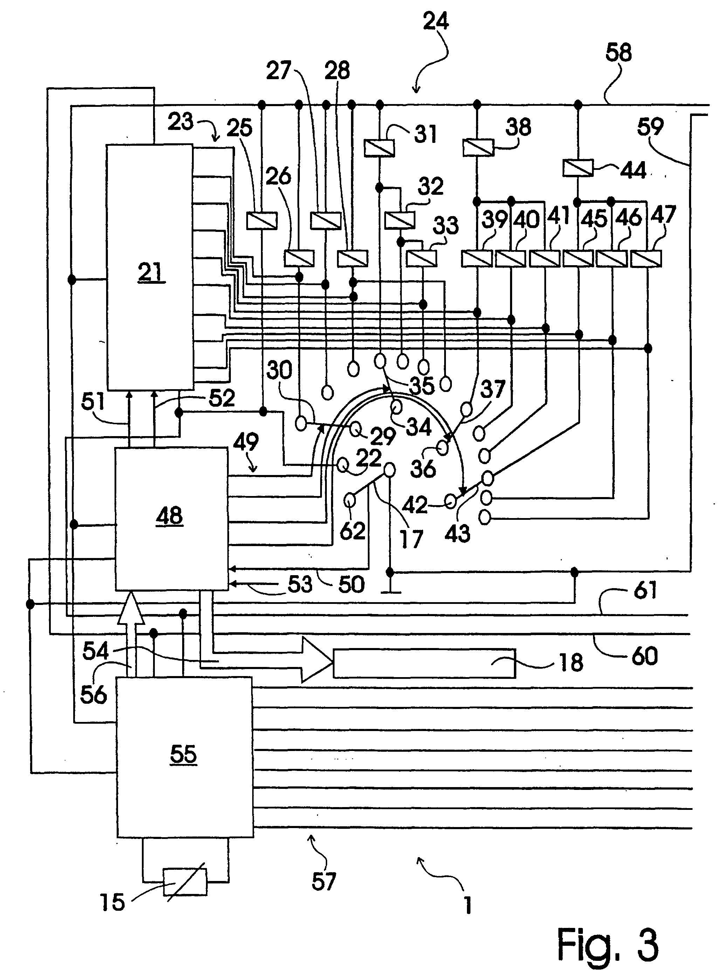

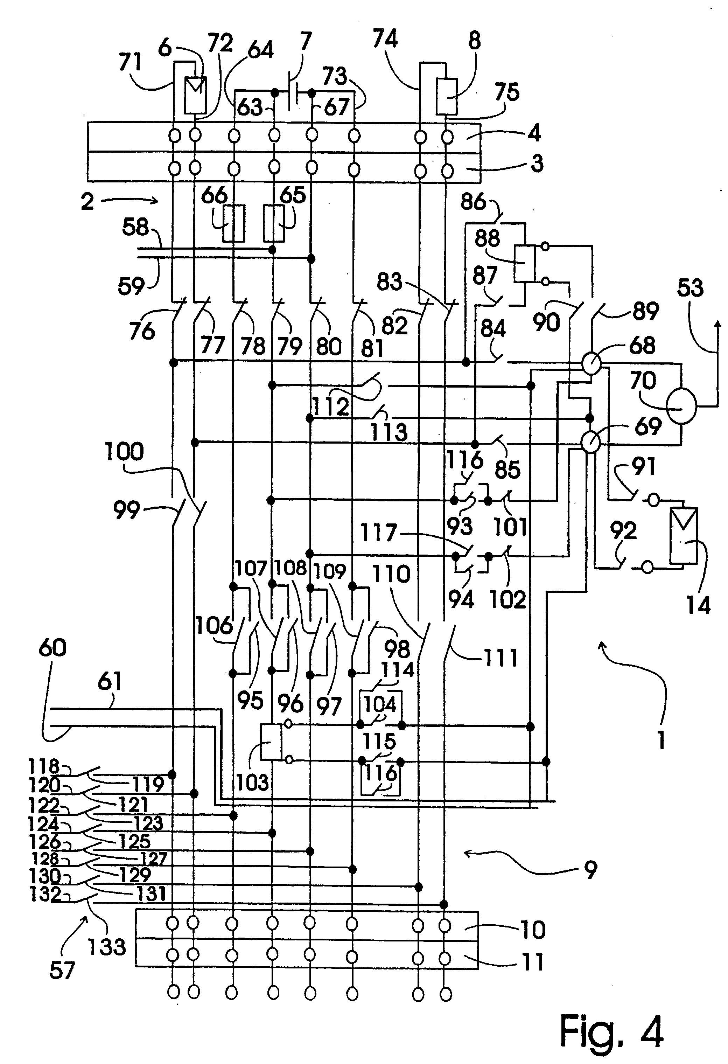

Fig. 3 und Fig. 4 zeigen den funktionalen Aufbau der Anordnung gemäß Fig. 1 zu Zwecken der Erläuterung anhand von exemplarischen Schaltbildern.

Fig. 3 zeigt insbesondere Ansteuermittel der beispielhaft erläuterten erfindungsgemäßen Vorrichtung. Gemäß Fig. 3 verfügt die Vorrichtung über eine Selbsttesteinheit 21, die in einer Selbsttesteinstellung 22 der Testwahlschalteinheit 17 ansprechbar ist. Die Selbsttesteinheit 21 ist über eine Anzahl von Selbsttestansteuerverbindungen 23 mit einer Anzahl von Ansteuermodulen einer Ansteueranordnung 24 der Prüfmittel verbunden. Die Ansteueranordnung 24 umfaßt ein Selbsttestansteuermodul 25, das in der Selbsttestansteuereinstellung 22 der Testwahlschalteinheit 17 direkt ansprechbar ist. Die Ansteueranordnung 24 weist weiterhin ein erstes Solargeneratortestansteuermodul 26, ein zweites Solargeneratortestansteuermodul 27 und ein drittes Solargeneratortestansteuermodul 28 auf, die in einer Solargeneratortesteinstellung 29 der Testwahlschalteinheit 17 über ein Solargeneratortestschaltmodul 30 ansprechbar sind.

Die Ansteueranordnung 24 verfügt weiterhin über ein erstes Batterietestansteuermodul 31, ein zweites Batterietestansteuermodul 32 sowie ein drittes Batterietestansteuermodul 33, die kaskadiert in einer Batterietesteinstellung 34 der Testwahlschalteinheit 17 über ein Batterietestschaltmodul 35 ansteuerbar sind. In einer weiteren Einstellung des Batterietestschaltmoduls 35 ist das dritte Solargeneratortestansteuermodul 28 ansprechbar.

In einer Lasttesteinstellung 36 der Testwahischalteinheit 17 sind in jeder Einstellung eines Lasttestschaltmoduls 37 ein Lasttesthauptansteuermodul 38 sowie in jeweils einer Stellung zusätzlich ein erstes Lasttestansteuermodul 39, ein zweites Lasttestansteuermodul 40 und ein drittes Lasttestansteuermodul 41 der Ansteueranordnung 24 ansprechbar, so daß die Lasttestansteuermodule 39, 40, 41 jeweils einzeln zusammen mit dem Lasttesthauptansteuermodul 38 aktivierbar sind. Entsprechend ist in einer Ladereglertesteinstellung 42 der Testwahlschalteinheit 17 über ein Ladereglertestschaltmodul 43 ein Ladereglertesthauptansteuermodul 44 sowie in verschiedenen Einstellungen des Ladereglertestschaltmoduls 43 zusätzlich ein erstes Ladereglertestansteuermodul 45, ein zweites Ladereglertestansteuermodul 46 sowie ein drittes Ladereglertestansteuermodul 47 zusammen mit dem Ladereglertesthauptansteuermodul 44 ansprechbar.

Weiterhin verfügt gemäß Fig. 3 die beispielhafte Vorrichtung über eine Steuereinheit 48, die über Einzeltestansteuerverbindungen 49 mit dem Solargeneratortestschaltmodul 30, dem Batterietestschaltmodul 35, dem Lasttestschaltmodul 37 sowie dem Ladereglertestschaltmodul 43 zu deren Ansteuerung in Verbindung steht. Über eine Testwahlstatusverbindung 50 ist die Einstellung der Testwahischalteinheit 17 der Steuereinheit 48 einspeisbar. Mit der Steuereinheit 48 sind weiterhin der Selbsttesteinheit 21 über eine Schaltteststeuerverbindung 51 und eine Ansteuertestverbindung 52 Steuersignale zum Ausführen eines Selbsttests einspeisbar. Eine Spannungsmeßwertverbindung 53 dient dem Einspeisen eines Spannungsmeßwertes in die Steuereinheit 48. Weiterhin ist die Steuereinheit 48 über eine Anzeigebusleitung 54 mit der Flüssigkristallanzeige 18 verbunden.

Gemäß Fig. 3 weist die Vorrichtung weiterhin eine Ladereglertesteinheit 55 auf, an die der Temperatursensor 15 angeschlossen ist. Die Ladereglertesteinheit 55 steht über eine Ladereglertestbusverbindung 56 mit der Steuereinheit 48 in Verbindung. Weiterhin ist die Ladereglertesteinheit 55 mit einer Anzahl von Ladereglertestverbindungen 57 verknüpft.

Ein positiver Batterieanschluß 58 liegt sowohl an den Ansteuermodulen 25 bis 28, 31 bis 33, 38 bis 41, 44 bis 47 als auch an der Selbsttesteinheit 21, der Steuereinheit 48 sowie der Ladereglertesteinheit 55 an. Ein negativer Batterieanschluß 59 liegt an der Steuereinheit 48 sowie an der Ladereglertesteinheit 55 an, so daß diese zusammen mit der Flüssigkristallanzeige 18 extern mit elektrischer Energie versorgbar sind. Weiterhin ist die Testwahlschalteinheit 17 an den negativen Batterieanschluß 59 gelegt, wobei in den Einstellungen 22, 29, 34, 36, 42 der Testwahlschalteinheit 17 die Selbsttesteinheit 21 beziehungsweise die Ansteuermodule 25 bis 28, 31 bis 33, 38 bis 41, 44 bis 47 über die entsprechenden Schaltmodule 30, 35, 37, 43 an den negativen Batterieanschluß 59 zur entsprechenden Aktivierung schaltbar sind. Ein positiver Spannungsmeßabgriff 60 sowie ein negativer Spannungsmeßabgriff 61 sind an die Selbsttesteinheit 21 sowie die Ladereglertesteinheit 55 gelegt.

In einer Abschalteinstellung 62 der Testwahlschalteinheit 17 gemäß Fig. 3 ist schließlich das Handtestgerät 1 deaktivierbar.

Fig. 4 zeigt insbesondere Schaltmittel der beispielhaft erläuterten Vorrichtung in der Anordnung gemäß Fig. 1. Eine positive Batterielastleitung 63 und eine positive Batterieprüfleitung 64 sind jeweils mit Sicherungen 65, 66 abgesichert. An der positiven Batterielastleitung 63 ist der positive Batterieanschluß 58 und an einer negativen Batterielastleitung 67 ist der negative Batterieanschluß 59 angeschlossen. An einem positiven Abgriff 68 ist der positive Spannungsmeßabgriff 60 und einem negativen Abgriff 69 ist der negative Spannungsmeßabgriff 61 angeschlossen. Weiterhin ist an dem positiven Abgriff 68 und dem negativen Abgriff 69 ein Gleichspannungsmesser 70 angeschlossen, der über die Spannungsmeßwertverbindung 53 mit der Steuereinheit 48 in Verbindung steht.

Der Solargenerator 6 ist mit einer positiven Solargeneratorleitung 71 und einer negativen Solargeneratorleitung 72 an die erste Buchsenleiste 4 angeschlossen. Die Batterie 7 ist mit der positiven Batterielastleitung 63, der positiven Batterieprüfleitung 64, der negativen Batterielastleitung 67 sowie einer negativen Batterieprüfleitung 73 mit der ersten Buchsenleiste 4 kontaktiert. Die Last 8 schließlich ist mit einer positiven Lastleitung 74 und einer negativen Lastleitung 75 an die erste Buchsenleiste 4 angeschlossen, in die in der Darstellung gemäß Fig. 4 der erste Teststecker 3 eingesteckt ist.

Das erläuterte Ausführungsbeispiel einer erfindungsgemäßen Vorrichtung verfügt zum Ausführen eines Selbsttests in der Selbsttesteinstellung 22 der Testwahlschalteinheit 17 über einen in die positive Solargeneratorleitung 71 gelegten ersten Selbsttestschalter 76, einen in die negative Solargeneratorleitung 72 gelegten zweiten Selbsttestschalter 77, einen in die positive Batterieprüfleitung 64 gelegten dritten Selbsttestschalter 78, einen in die positive Batterielastleitung 73 gelegten vierten Selbsttestschalter 79, einen in die negative Batterielastleitung 67 gelegten fünften Selbsttestschalter 80, einen in die negative Batterieprüfleitung 73 gelegten sechsten Selbsttestschalter 81, einen in die positive Lastleitung 74 gelegten siebten Selbsttestschalter 82 sowie einen in die negative Lastleitung 75 gelegten achten Selbsttestschalter 83. Die als Öffner ausgebildeten Selbsttestschalter 76 bis 83 sind in der Selbsttesteinstellung 22 der Testwahlschalteinheit 17 bei Ansteuerung des Selbsttestansteuermoduls 25 öffenbar, so daß der Solargenerator 6, die Batterie 7 sowie die Last 8 von dem Handtestgerät 1 abgekoppelt sind.

Zum Ausführen eines Solargeneratortests in der Solargeneratortesteinstellung 29 der Testwahlschalteinheit 17 sind zwischen der positiven Solargeneratorleitung 71 sowie dem positiven Abgriff 68 ein erster Solargeneratortestschalter 84 und zwischen der negativen Solargeneratorleitung 72 sowie dem negativen Abgriff 69 ein zweiter Solargeneratortestschalter 85 gelegt, die über das erste Solargeneratortestansteuermodul 26 schließbar sind. Weiterhin sind an die positive Solargeneratorleitung 71 ein dritter Solargeneratortestschalter 86 und an die negative Solargeneratorleitung 72 ein vierter Solargeneratortestschalter 87 gelegt, die mit dem zweiten Solargeneratortestansteuermodul 27 schließbar sind. Der dritte Solargeneratortestschalter 86 und der vierte Solargeneratortestschalter 87 sind mit ihren weiteren Anschlüssen an eine erste Solargeneratormeßbrücke 88 geschaltet, die wiederum über einen fünften Solargeneratortestschalter 89 an den positiven Abgriff 68 und über einen sechsten Solargeneratortestschalter 90 an den negativen Abgriff 69 gelegt sind, die jeweils durch das zweite Solargeneratortestansteuermodul 27 schließbar sind. Weiterhin sind ein an den positiven Abgriff 68 geschalteter siebter Solargeneratortestschalter 91 und ein achter Solargeneratortestschalter 92 vorgesehen, die über das dritte Solargeneratortestansteuermodul 28 unter Verbindung des Referenzsolargenerators 14 mit dem positiven Abgriff 68 beziehungsweise dem negativen Abgriff 69 schließbar sind.

Zum Ausführen eines Batterietests in der Batterietesteinstellung 34 der Testwahlschalteinheit 17 sind zwischen der positiven Batterielastleitung 63 sowie dem positiven Abgriff 68 ein erster Batterietestschalter 93 und zwischen der negativen Batterielastleitung 67 sowie dem negativen Abgriff 69 ein zweiter Batterietestschalter 94 gelegt, die über das erste Batterietestansteuermodul 31 bei entsprechender Einstellung des Batterietestschaltmoduls 35 schließbar sind. Weiterhin sind in die positive Batterieprüfleitung 64 ein dritter Batterietestschalter 95, in die positive Batterielastleitung 63 ein vierter Batterietestschalter 96, in die negative Batterielastleitung 67 ein fünfter Batterietestschalter 97 sowie in die negative Batterieprüfleitung 73 ein sechster Batterietestschalter 98 gelegt, die über das zweite Batterietestansteuermodul 32 schließbar sind. In die positive Solargeneratorleitung 71 ist ein siebter Batterietestschalter 99 und in die negative Solargeneratorleitung 72 ist ein achter Batterietestschalter 100 gelegt, die ebenfalls durch das zweite Batterietestansteuermodul 32 schließbar sind.

Zwischen dem ersten Batterietestschalter 93 sowie dem positiven Abgriff 68 ist ein neunter Batterietestschalter 101 und zwischen dem zweiten Batterietestschalter 94 sowie dem negativen Abgriff 69 ein zehnter Batterietestschalter 102 gelegt, die als Öffner ausgebildet und über das dritte Batterietestansteuermodul 33 betätigbar sind. In der positiven Batterielastleitung 63 ist eine Batteriemeßbrücke 103 gelegt, an deren Abgriffen ein elfter Batterietestschalter 104 und ein zwölfter Batterietestschalter 105 angeschlossen sind. Der elfte Batterietestschalter 104 und der zwölfte Batterietestschalter 105 sind mit dem dritten Batterietestansteuermodul 33 betätigbar. Der elfte Batterietestschalter 104 ist mit seinem weiteren Anschluß an dem positiven Abgriff 68, und der zwölfte Batterietestschalter 105 ist entsprechend an den negativen Abgriff 69 kontaktiert.

Parallel zu dem dritten Batterietestschalter 95, dem vierten Batterietestschalter 96, dem fünften Batterietestschalter 97 sowie dem sechsten Batterietestschalter 98 sind jeweils ein erster Lasttesthauptschalter 106, ein zweiter Lasttesthauptschalter 107, ein dritter Lasttesthauptschalter 108 sowie ein vierter Lasttesthauptschalter 109 gelegt, die zum Ausführen eines Lasttests in der Lasttesteinstellung 36 der Testwahlschalteinheit 17 in der entsprechenden Einstellung des Lasttestschaltmoduls 37 mit dem Lasttesthauptansteuermodul 38 aktivierbar sind. Weiterhin sind in die positive Lastleitung 74 ein fünfter Lasttesthauptschalter 110 und in die negative Lastleitung 75 ein sechster Lasttesthauptschalter 111 gelegt, die ebenfalls durch das Lasttesthauptansteuermodul 38 schließbar sind.

Zwischen der negativen Batterielastleitung 67 sowie dem positiven Abgriff 68 ist ein erster Lasttestschalter 112 und zwischen der negativen Batterieprüfleitung 73 sowie dem negativen Abgriff 69 ist ein zweiter Lasttestschalter 113 gelegt, die in der entsprechenden Einstellung des Lasttestschaltmoduls 37 mit dem ersten Lasttestansteuermodul 39 schließbar sind. Parallel zu dem elften Batterietestschalter 104 sowie dem zwölften Batterietestschalter 105 sind ein dritter Lasttestschalter 114 beziehungsweise ein vierter Lasttestschalter 115 gelegt, die in der entsprechenden Einstellung des Lasttestschaltmoduls 37 mit dem zweiten Lasttestansteuermodul 40 schließbar sind. Schließlich sind parallel zu dem ersten Batterietestschalter 93 und dem zweiten Batterietestschalter 94 ein fünfter Lasttestschalter 116 und ein sechster Lasttestschalter 117 gelegt, die in der entsprechenden Einstellung des Lasttestschaltmoduls 37 mit dem dritten Lasttestansteuermodul 41 schließbar sind.

Zum Ausführen eines Ladereglertests in der Ladereglertesteinstellung 42 der Testwahlschalteinheit 17 weisen die Ladereglertestverbindungen 57 eine Ladereglertestverbindung 118 auf, die über einen ersten Ladereglertesthauptschalter 119 mit dem Anschluß der positiven Solargeneratorleitung 71 an den Laderegler 12 verbunden ist. Entsprechend sind eine zweite Ladereglertestverbindung 120 und ein zweiter Ladereglertesthauptschalter 121 an den Anschluß der negativen Solargeneratorleitung 72 an den Laderegler 12, eine dritte Ladereglertestverbindung 122 und ein dritter Ladereglertesthauptschalter 123 an den Anschluß der positiven Batterieprüfleitung 64 an den Laderegler 12, eine vierte Ladereglertestverbindung 124 und ein vierter Ladereglertesthauptschalter 125 an den Anschluß der positiven Batterielastleitung 63 an den Laderegler 12, eine fünfte Ladereglertestverbindung 126 und ein fünfter Ladereglertesthauptschalter 127 an den Anschluß der negativen Batterielastleitung 67 an den Laderegler 12, eine sechste Ladereglertestverbindung 128 und ein sechster Ladereglertesthauptschalter 129 an den Anschluß der negativen Batterieprüfleitung 73 an den Laderegeler 12, eine siebte Ladereglertestverbindung 130 und ein siebter Ladereglertesthauptschalter 131 an den Anschluß der positive Lastleitung 74 an den Laderegler 12 sowie eine achte Ladereglertestverbindung 132 und ein achter Ladereglertesthauptschalter 133 an den Anschluß der negativen Lastleitung 75 an den Laderegler 12 angeschlossen. Die Ladereglertesthauptschalter 119, 121, 123, 125, 127, 129, 131, 133 sind in der Ladereglertesteinstellung 42 der Testwahlschalteinheit 17 sowie den entsprechenden Einstellungen des Ladereglertestschaltmoduls 43 mit dem Ladereglertesthauptansteuermodul 44 schließbar.

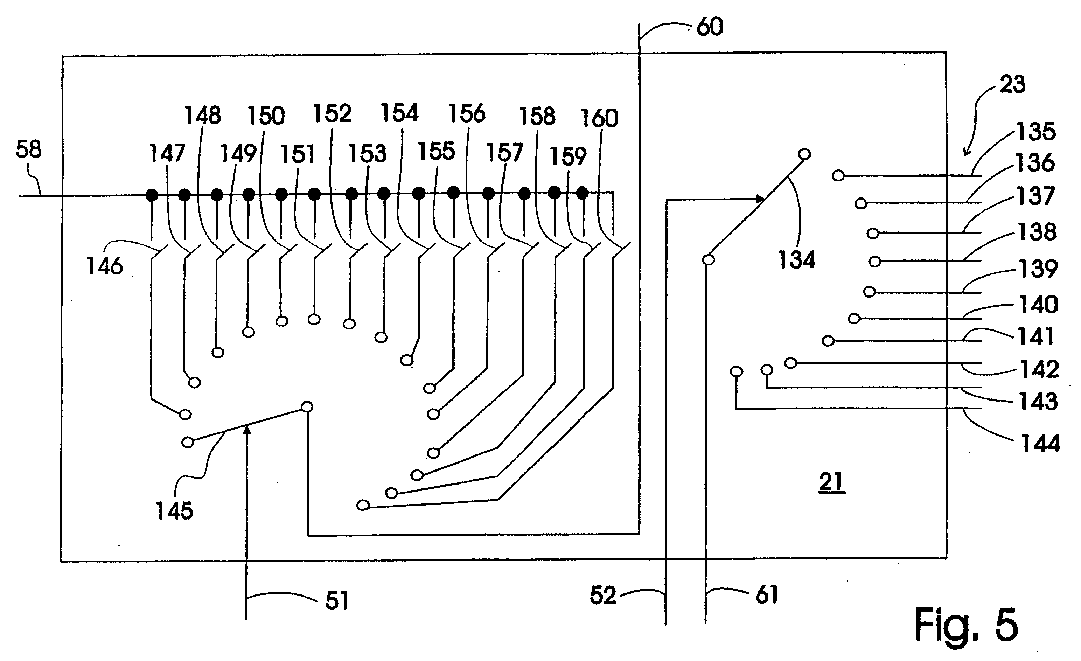

Fig. 5 zeigt in einem Funktionsschaltbild die Selbsttesteinheit 21 des Handtestgeräts 1 gemäß Fig. 3 und Fig. 4. Die Selbsttesteinheit 21 verfügt über ein Ansteuertestschaltmodul 134, das über die Ansteuerselbsttestverbindung 52 betätigbar ist. An die Ausgänge des Ansteuertestschaltmoduls 134 sind die Selbsttestansteuerverbindungen 23 angeschlossen. Mit einer ersten Selbsttestansteuerverbindung 135 ist das erste Solargeneratortestansteuermodul 26 zum Test einer ordnungsgemäßen Funktionsweise ansteuerbar. Mit einer zweiten Selbsttestansteuerverbindung 136 ist das zweite Solargeneratortestansteuermodul 27 und mit einer dritten Selbsttestansteuerverbindung 137 ist das dritte Solargeneratortestansteuermodul 28 zu Funktionstestzwecken betätigbar. Mit einer vierten Selbsttestansteuerverbindung 138 ist das dritte Batterietestansteuermodul 33 sowie die kaskadierten weiteren Batterietestansteuermodule 31, 32 auf ordnungsgemäße Funktionsweise prüfbar. Mit einer fünften Selbsttestansteuerverbindung 139, mit einer sechsten Selbsttestansteuerverbindung 140 sowie mit einer siebten Selbsttestansteuerverbindung 141 sind das erste Lasttestansteuermodul 39, das zweite Lasttestansteuermodul 40 beziehungsweise das dritte Lasttestansteuermodul 41 zusammen mit dem Lasttesthauptansteuermodul 38 überprüfbar. Mit einer achten Ansteuertestverbindung 142, einer neunten Selbsttestansteuerverbindung 143 beziehungsweise einer zehnten Selbsttestansteuerverbindung 144 sind das erste Laderegleransteuermodul 45, das zweite Ladereglertestansteuermodul 46 beziehungsweise das dritte Ladereglertestansteuermodul 47 zusammen mit dem Ladereglertesthauptansteuermodul 44 überprüfbar.

Der Funktionstest des Selbsttestansteuermoduls 25 erfolgt selbstätig in der Selbsttesteinstellung 22 der Testwahlschalteinheit 17 durch das Starten des Selbsttests selbst. Die Funktionsprüfung des ersten Batterietestansteuermoduls 31 und des zweiten Batterietestansteuermoduls 32, die mit dem dritten Batterietestansteuermodul 33 kaskadiert sind, erfolgt durch die Funktionsprüfung des dritten Batterietestansteuermoduls 33. Entsprechend erfolgen die Funktionsprüfungen des ersten Lasttesthauptansteuermoduls 38, dem die Lasttestansteuermodule 39, 40, 41 nachgeschaltet sind sowie die Funktionsprüfung des Ladereglertesthauptansteuermoduls 44, dem die Ladereglertestansteuermodule 45, 46, 47 nachgeschaltet sind, über die Funktionsprüfung der nachgeschalteten Lasttestansteuermodule 39, 40, 41 beziehungsweise Ladereglertestansteuermodule 45, 46, 47.

Weiterhin verfügt die Selbsttesteinheit 21 gemäß Fig. 5 über ein Schalttestschaltmodul 145, das an die Schaltteststeuerverbindung 51 angeschlossen ist. An die Ausgänge des Schalttestschaltmoduls 145 sowie an den positiven Batterieanschluß 58 ist ein neunter Solargeneratortestschalter 146 gelegt, der über die erste Selbsttestansteuerverbindung 135 mit dem ersten Solargeneratortestansteuermodul 26 schließbar ist. Entsprechend ist ein zehnter Solargeneratortestschalter 147, der mit dem über die zweite Selbsttestansteuerverbindung 136 betätigbaren zweiten Solargeneratortestansteuermodul 27 schließbar ist, über das Schalttestschaltmodul 145 aktivierbar. Schließlich ist ein elfter Solargeneratortestschalter 148 vorgesehen, der über die dritte Selbsttestansteuerverbindung 137 mittels des dritten Solargeneratortestansteuermoduls 28 schließbar ist.

Ein 13. Batterietestschalter 149, ein 14. Batterietestschalter 150 und ein 15. Batterietestschalter 151, die über die vierte Selbsttestansteuerverbindung 138 mit den kaskadierten Batterietestansteuermodulen 31, 32, 33 bei Ansteuerung des dritten Batterietestansteuermoduls 33 schließbar sind, lassen sich in der entsprechenden Einstellung des Ansteuertestschaltmoduls 134 nacheinander über entsprechende Einstellungen des Schalttestschaltmoduls 145 aktivieren. Ein siebter Lasttesthauptschalter 152 sowie ein siebter Lasttestschalter 153, ein achter Lasttestschalter 154 sowie ein neunter Lasttestschalter 155 sind über das Lasttesthauptansteuermodul 38 sowie die Lasttestansteuermodule 39, 40, 41, die über die fünfte Selbsttestansteuerverbindung 139, die sechste Selbsttestansteuerverbindung 140 sowie die siebte Selbsttestansteuerverbindung 141 betätigbar sind, schließbar.

Entsprechend sind ein neunter Ladereglertesthauptschalter 156 sowie ein erster Ladereglertestschalter 157, ein zweiter Ladereglertestschalter 158 sowie ein dritter Ladereglertestschalter 159, die von der achten Selbsttestansteuerverbindung 142, der neunten Selbsttestansteuerverbindung 143 beziehungsweise der zehnten Selbsttestansteuerverbindung 144 gesteuert über das Ladereglertesthauptansteuermodul 44 beziehungsweise die Ladereglertestansteuermodule 45, 46, 47 betätigbar sind, über das Schalttestschaltmodul 145 mit dem positiven Spannungsmeßabgriff 60 verbindbar.

Schließlich ist ein neunter Selbsttestschalter 160 vorgesehen, der über das Selbsttestschaltmodul 25 in der Selbsttesteinstellung 22 der Testwahlschalteinheit 17 schließbar ist.

Zum Durchführen des Selbsttests sind das Ansteuertestschaltmodul 134 und das Schalttestschaltmodul 145 von der Steuereinheit 48 so ansteuerbar, daß bei Beaufschlagen der an die Selbsttestansteuerverbindungen 23, 135 bis 144 angeschlossenen Schaltmodule 26 bis 28, 31 bis 33, 38 bis 41, 44 bis 47 sowie das in der Selbsttesteinstellung 22 der Testwahlschalteinheit 17 angesteuerte Selbsttestschaltmodul 25 aktivierbar und die ordnungsgemäße Funktionsweise der über das Schalttestschaltmodul 145 abfragbaren Testschalter 146 bis 160 durch eine Überprüfung der Anzeige des Gleichspannungsmessers 70 auf ordnungsgemäße Funktionsweise prüfbar sind. Dadurch ist sichergestellt, daß die zugehörigen Schaltmodule 25 bis 28, 31 bis 33, 38 bis 41, 44 bis 47 ordnungsgemäß funktionieren.

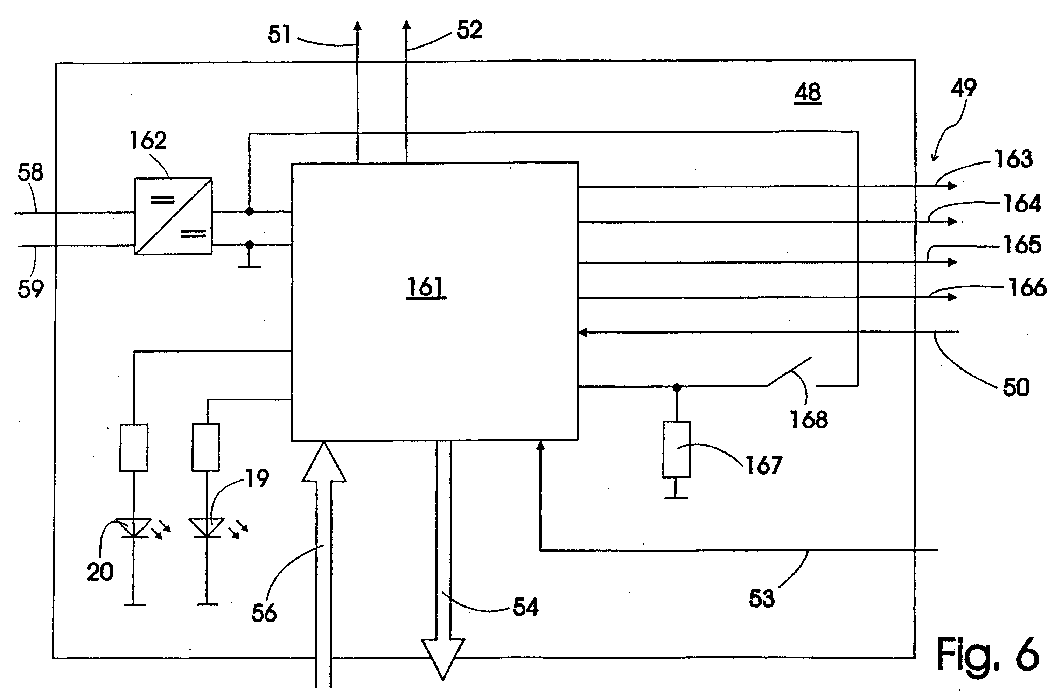

Fig. 6 zeigt in einem Funktionsschaltbild den Aufbau der Steuereinheit 48 des Handtestgeräts 1 gemäß Fig. 3 und Fig. 4. Die Steuereinheit 48 verfügt über ein beispielsweise als sogenannter Microcontroller ausgeführtes Zentralmodul 161, das über einen Gleichspannungswandler 162 an den positiven Batterieanschluß 58 und den negativen Batterieanschluß 59 zur externen Energieversorgung mit einer im wesentlichen konstanten Gleichspannung auch bei schwankenden Spannungen der Batterie 7 angeschlossen ist. Mit dem Zentralmodul 161 ist weiterhin über die Schaltteststeuerverbindung 51 beziehungsweise die Selbsttestansteuerverbindung 52 das Ansteuertestschaltmodul 134 beziehungsweise das Schalttestschaltmodul 145 der Selbsttesteinheit 21 ansteuerbar. Weiterhin sind mit dem Zentralmodul 161 die Einzeltestansteuerverbindungen 49 aktivierbar, wobei über eine Solargeneratoreinzeltestansteuerverbindung 163 in der Solargeneratortesteinstellung 30 der Testwahlschalteinheit 17 das Solargeneratortestschaltmodul 29 betätigbar ist. Entsprechend sind über eine Batterieeinzeltestansteuerverbindung 164, eine Lasteinzeltestansteuerverbindung 165 beziehungsweise eine Ladereglereinzeltestansteuerverbindung 166 in der Batterietesteinstellung 34, der Lasttesteinstellung 36 beziehungsweise der Ladereglertesteinstellung 42 der Testwahlschalteinheit 17 das Batterietestschaltmodul 35, das Lasttestschaltmodul 37 beziehungsweise das Ladereglertestschaltmodul 43 in den entsprechenden Einstellungen aktivierbar.

Über die Testwahistatusverbindung 50 ist dem Zentralmodul 161 die aktuelle Einstellung der Testwahlschalteinheit 17 einspeisbar. Weiterhin ist das Zentralmodul 161 über die Spannungsmeßwertverbindung 53 mit dem von dem Gleichspannungsmesser 70 an den Abgriffen 68, 69 gemessenen Gleichspannungswerten beaufschlagbar. Über die Anzeigebusleitung 54 steht das Zentralmodul 161 mit der Flüssigkristallanzeige 18 zur Ausgabe beispielsweise von Betriebszuständen des Handtestgeräts 1 und von Kenngrößen in Verbindung. Über die Ladereglertestbusverbindung 56 sind dem Zentralmodul 161 von der Ladereglertesteinheit 55 aufgenommene beziehungsweise erzeugte Daten einspeisbar. Weiterhin sind an das Zentralmodul 161 die Tiefentladeschutzanzeige 19 und die Überladeschutzanzeige 20, die beispielsweise als lichtemittierende Dioden ausgeführt sind, angeschlossen. Ein an die positive Ausgangsspannung des Gleichspannungswandlers 162 angeschlossener und über einen Schutzwiderstand 167 mit dem Zentralmodul 161 verbundener zehnter Selbsttestschalter 168, der über das Selbsttestansteuermodul 25 betätigbar ist, dient im Rahmen des Selbsttests einer Funktionsüberprüfung des Zentralmoduls 161.

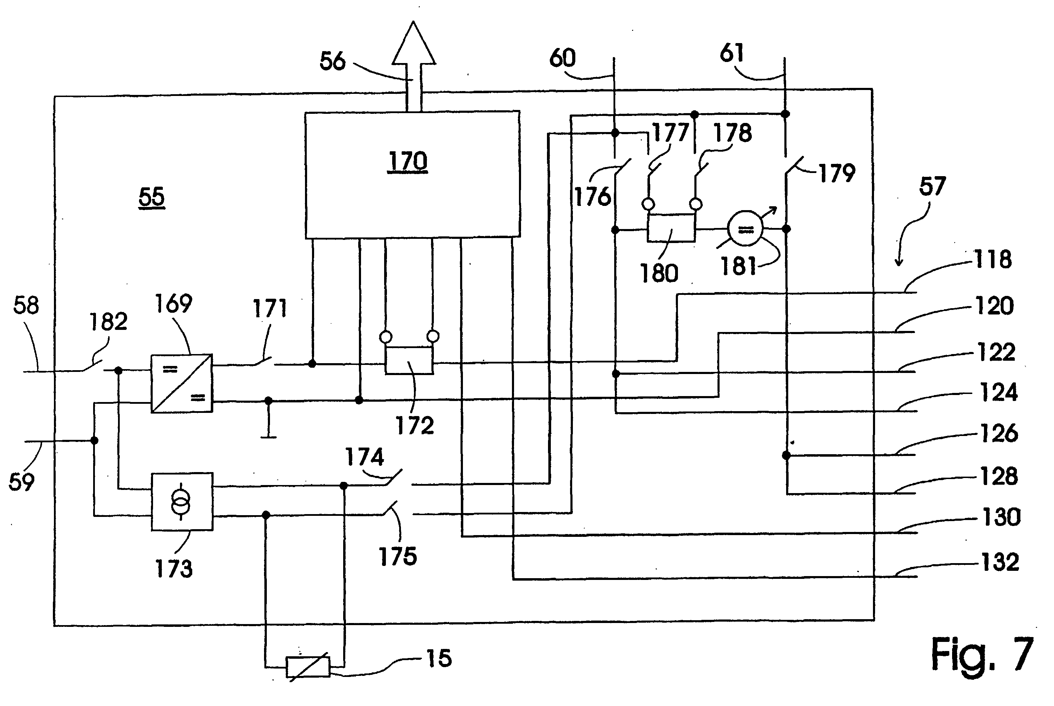

Fig. 7 zeigt in einem Funktionsschaltbild den Aufbau der Ladereglertesteinheit 55 des Handtestgeräts 1 gemäß Fig. 3. Die Ladereglertesteinheit 55 ist mit einem Gleichspannungswandler 169 zur externen Versorgung mit elektrischer Energie einer konstanten Gleichspannung auch bei schwankender Spannung der Batterie 7 an die Batterieanschlüsse 58, 59 gelegt. Die Ausgänge des Gleichspannungswandlers 169 der Ladereglertesteinheit 55 sind einem Schutzlogikmodul 170 eingespeist, wobei zwischen dem positiven Ausgang des Gleichspannungswandlers 169 und einem Eingang des Schutzlogikmoduls 170 ein vierter Ladereglertestschalter 171 gelegt ist. Weiterhin ist an den positiven Ausgang des Gleichspannungswandlers 169 der Ladereglertesteinheit 55 dem vierten Ladereglertestschalter 171 nachgeordnet eine erste Ladereglermeßbrücke 172 gelegt, deren Ausgänge mit dem Schutzlogikmodul 170 verbunden sind.

Weiterhin sind an das Schutzlogikmodul 170 die siebte Ladereglertestverbindung 130 und die achte Ladereglertestverbindung 132 angeschlossen, die mit dem Anschluß der positiven Lastleitung 74 beziehungsweise der negativen Lastleitung 75 an den Laderegler 12 kontaktiert sind. Die erste Ladereglertestverbindung 118 und die zweite Ladereglertestverbindung 120, die mit den jeweiligen Anschlüssen der positiven Solargeneratorleitung 71 und der negativen Solargeneratorleitung 72 an den Laderegler 12 verbunden sind, sind ebenfalls mit den mit dem Gleichspannungswandler 169 der Ladereglertesteinheit 55 kontaktierten Eingängen des Schutzlogikmoduls 170 verbunden.

An die Batterieanschlüsse 58, 59 ist weiterhin eine Konstantstromquelle 173 der Ladereglertesteinheit 55 gelegt, die zum einen den Temperatursensor 15 permanent mit elektrischer Energie versorgt. Den Anschlüssen des Temperatursensors 15 an die Konstantstromquelle 173 nachgeordnet sind in jeweils eine Ausgangsleitung der Konstantstromquelle 173 ein vierter Ladereglertestschalter 174 und ein fünfter Ladereglertestschalter 175 gelegt, die mit dem ersten Ladereglertestansteuermodul 45 schließbar sind. Der weitere Ausgang des vierten Ladereglertestschalters 174 ist mit dem positiven Spannungsmeßabgriff 60 verbunden, an den weiterhin ein sechster Ladereglertestschalter 176 und ein siebter Ladereglertestschalter 177 gelegt sind. Der weitere Anschluß des fünften Ladereglertestschalters 175 ist an den negativen Spannungsmeßabgriff 61 gelegt, an den weiterhin ein achter Ladereglertestschalter 178 und ein neunter Ladereglertestschalter 179 kontaktiert sind. Der siebte Ladereglertestschalter 177 und der achte Ladereglertestschalter 178 sind über das zweite Ladereglertestansteuermodul 46 aktivierbar, während der sechste Ladereglertestschalter 176 und der neunte Ladereglertestschalter 179 über das dritte Ladereglertestansteuermodul 47 schließbar sind.

Zwischen die weiteren Anschlüsse des siebten Ladereglertestschalters 177 und des achten Ladereglertestschalters 178 sind die Ausgänge einer zweiten Ladereglermeßbrücke 180 gelegt, die eingangsseitig zum einen mit der an den sechsten Ladereglertestschalter 176 gelegten vierten Ladereglertestverbindung 124 und zum anderen über eine mittels der Spannungseingabeeinheit 16 über den Betriebsspannungsbereich der Batterie 7 von beispielsweise etwa 10 Volt bis 16 Volt einstellbare Referenzspannungsquelle 181 an den weiteren Anschluß des sowohl an die fünfte Ladereglertestverbindung 126 als auch die sechste Ladereglertestverbindung 128 angeschlossenen weiteren Anschluß des neunten Ladereglertestschalters 179 gelegt ist. Zwischen dem positiven Batterieanschluß 58 sowie dem Gleichspannungswandler 169 der Ladereglertesteinheit 55 und der Konstantstromquelle 173 ist ein vierter Ladereglertesthauptschalter 182 vorgesehen, der mit Ladereglertesthauptansteuermodul 44 zum Aktivieren der Ladereglertesteinheit 55 in der Ladereglertesteinstellung 42 der Testwahlschalteinheit 17 schließbar ist.

In der Anordnung gemäß Fig. 1 ist mit dem anhand Fig. 2 bis Fig. 7 erläuterten Handtestgerät 1 eine Überprüfung der Komponenten 6, 7, 8, 12 der Solaranlage einzeln und in betriebstypischen Verschaltungen wie folgt durchführbar. Nach Überführen der Testwahischalteinheit 17 von der Abschalteinstellung 62 in die Selbsttesteinstellung 22 erfolgt von dem Zentralmodul 161 über die Selbstteststeuerverbindung 51 und die Selbsttestansteuerverbindung 52 gesteuert mittels der Selbsttesteinheit 21 eine Überprüfung der Ansteuermodule 25 bis 28, 31 bis 33, 38 bis 41, 44 bis 47 auf ordnungsgemäße Funktionsweise über die Kontrolle des ordnungsgemäßen Schließens der Testschalter 146 bis 160 mittels der Anzeige von Spannungswerten auf der Flüssigkristallanzeige 18.

In der Solargeneratortesteinstellung 29 der Testwahlschalteinheit 17 wird in der das erste Solargeneratortestansteuermodul 26 aktivierenden Einstellung des Solargeneratortestschaltmoduls 30 die Leerlaufspannung des Solargenerators 6 gemessen. In der das zweite Solargeneratortestansteuermodul 27 aktivierenden Einstellung des Solargeneratortestschaltmoduls 30 wird der Kurzschlußstrom und in der das dritte Solargeneratortestschaltmodul 28 aktivierenden Einstellung des Solargeneratortestschaltmoduls 30 aktivierten Einstellung wird die zum Zeitpunkt der beiden letztgenannten Überprüfungen herrschende aktuelle Strahlungsleistung pro Flächeneinheit der Sonneneinstrahlung, die sogenannte Irradiation, über den Referenzsolargenerator 14 erfaßt.

In der Batterietesteinstellung 34 der Testwahlschalteinheit 17 wird in einer allein das erste Batterietestansteuermodul 31 aktivierenden Einstellung des Batterietestschaltmoduls 35 die Leerlaufspannung der Batterie 7 gemessen. In der zusätzlich das zweite Batterietestansteuermodul 32 aktivieren Einstellung des Batterietestschaltmoduls 35 wird die Spannung der Batterie 7 bei zugeschaltetem Solargenerator 6 gemessen. In der weiterhin zu dem ersten Batterietestansteuermodul 31 sowie dem zweiten Batterietestansteuermodul 32 das dritte Batterietestansteuermodul 33 aktivierenden Einstellung des Batterietestschaltmoduls 35 wird der Batteriestrom bei zugeschaltetem Solargenerator 6 gemessen. In der das dritte Solargeneratortestansteuermodul 28 aktivierenden Einstellung des Batterietestschaltmoduls 35 wird über den Referenzsolargenerator 14 die Irradiation bei dem letztgenannten Batterietest, nämlich Batteriestrom bei zugeschaltetem Solargenerator 6, gemessen.

In der Lasttesteinstellung 36 der Testwahlschalteinheit 17 ist in der das Lasttesthauptansteuermodul 38 sowie das erste Lasttestansteuermodul 39 aktivierenden Einstellung des Lasttestschaltmoduls 37 die Spannung über der Last 8 erfaßbar. In der das Lasttesthauptansteuermodul 38 sowie das zweite Lasttestansteuermodul 40 aktivierenden Einstellung des Lasttestschaltmoduls 37 ist der durch die Last 8 fließende Strom meßbar. In der das Lasttesthauptansteuermodul 38 sowie das dritte Lasttestansteuermodul 41 aktivierenden Einstellung des Lasttestschaltmoduls 37 schließlich ist die zugehörige Spannung der Batterie 7 überprüfbar.

In der Ladereglertesteinstellung 42 der Testwahlschalteinheit 17 ist in der das Ladereglertesthauptansteuermodul 44 sowie das erste Ladereglertestansteuermodul 45 aktivierenden Einstellung des Lädereglerschaltmoduls 43 die Umgebungstemperatur erfaßbar. In der das Ladereglertesthauptansteuermodul 44 sowie das zweite Ladereglertestansteuermodul 46 aktivierenden Einstellung des Ladereglertestschaltmoduls 43 ist der Eigenverbrauch des Ladereglers 12 erfaßbar. In der das Laderegertesthauptansteuermodul 44 sowie das dritte Ladereglertestansteuermodul 47 aktivierenden Einstellung des Ladereglertestschaltmoduls 43 schließlich sind mittels des Schutzlogikmoduls 170 alle Schaltschwellen des Ladereglers 12, nämlich für den Tiefentladeschutz und den Überladeschutz über die Einstellung der Referenzspannungsquelle 181 überprüfbar.

Es versteht sich, daß die erfindungsgemäße Vorrichtung insbesondere in der beispielhaften Ausgestaltung gemäß Fig. 1 bis Fig. 7 auch mikroelektronisch integriert sowie unter wenigstens teilweiser Verwendung von Anwendungsprogrammen zum Ausführen der Funktionen realisierbar ist, ohne den Bereich der Erfindung zu verlassen.

## Patentansprüche

1. Vorrichtung zum Überprüfen von autonomen Solaranlagen, die als Komponenten wenigstens jeweils einen photovoltaischen Solargenerator (6), eine Batterie (7), einen Laderegler (12) und eine Last (8) umfassen, mit Anschlußmitteln zum Anschluß an den von den übrigen Komponenten (6, 7, 8) abgekoppelten Laderegler (12), mit Anschlußmitteln zum Anschluß an den oder jeden Solargenerator (6), die oder jede Batterie (7) sowie die oder jede Last (8) bei abgekoppeltem Laderegler (12) beziehungsweise abgekoppelten Ladereglern, mit Prüfmitteln, mit denen die Komponenten (6, 7, 8, 12) einzeln und in betriebstypischen Verschaltungen untereinander zum Ermitteln von für die Funktionsfähigkeit der zu überprüfenden Solaranlage charakteristischen Kenngrößen und Zustände überprüfbar sind, und mit Anzeigemitteln (18, 19, 20) zum Anzeigen der überprüften Kenngrößen und Zustände, wobei die Anschlußmittel Steckerleisten (3, 10) umfassen, die in zugeordnete Buchsenleisten (4, 11) einer mit einer Brücke (13) unterbrechbaren Anschlußschiene (5) für die Komponenten (6, 7, 8, 12) einfügbar sind.

2. Vorrichtung nach Anspruche 1 , **dadurch gekennzeichnet, daß** die Prüfmittel und Anzeigemittel über Spannungswandler (162, 169) zur externen Energieversorgung an wenigstens eine Batterie (6) der zu überprüfenden Solaranlage anschließbar sind.

3. Vorrichtung nach Anspruch 1 oder Anspruch 2, **dadurch gekennzeichnet, daß** die Prüfmittel eine einstellbare Referenzspannungsquelle (16, 181) umfassen.

4. Vorrichtung nach einem der Ansprüche 1 bis 3, **dadurch gekennzeichnet, daß** in einer Einstellung (22) der Prüfmittel und Anzeigemittel ein Selbsttest zum Überprüfen der ordnungsgemäßen Funktion durchführbar ist, bei dem die Funktionsfähigkeit von Ansteuermitteln und Schaltmitteln überprüfbar ist.

5. Vorrichtung nach einem der Ansprüche 1 bis 4, **dadurch gekennzeichnet, daß** in einer Einstellung (29) der Prüfmittel und Anzeigemittel ein Solargeneratortest durchführbar ist, bei dem die Leerfaufspannung und der Kurzschlußstrom des oder jedes Solargenerators (6) bei von dem oder jedem Laderegler (12) abgekoppelten Komponenten Batterie (6) beziehungsweise Batterien und Last (8) beziehungsweise Lasten meßbar ist.

6. Vorrichtung nach einem der Ansprüche 1 bis 5, **dadurch gekennzeichnet, daß** in einer Einstellung (34) der Prüfmittel und Anzeigemittel ein Batterietest der Batterie (7) beziehungsweise Batterien durchführbar ist, bei dem die Leerlaufspannung, die Spannung bei zugeschaltetem Solargenerator (6) beziehungsweise zugeschalteten Solargeneratoren und der Ladestrom bei abgekoppelter Last (8) beziehungsweise abgekoppelten Lasten meßbar ist.

7. Vorrichtung nach Anspruch 5 oder 6, **dadurch gekennzeichnet, daß** die Prüfmittel einen Referenzsolargenerator (14) zur Ermittlung der Sonneneinstrahlung umfassen.

8. Vorrichtung nach einem der Ansprüche 1 bis 7, **dadurch gekennzeichnet, daß** in einer Einstellung (36) der Prüfmittel und Anzeigemittel ein Lasttest durchführbar ist, bei dem die Spannung und der Strom der oder jeder Last (8) sowie die Spannung der oder jeder Batterie (7) bei abgekoppeltem Solargenerator (6) beziehungsweise abgekoppelten Solargeneratoren meßbar ist.

9. Vorrichtung nach einem der Ansprüche 3 bis 8, **dadurch gekennzeichnet, daß** in einer Einstellung (42) der Prüfmittel und Anzeigemittel zum Ausführen eines Ladereglertests bei abgekoppelten Komponenten Solargenerator (6) beziehungsweise Solargeneratoren, Batterie (7) beziehungsweise Batterien sowie Last (8) beziehungsweise Lasten die einstellbare Referenzspannungsquelle (16, 181) auf den oder jeden Laderegler (12) sohaltbar ist und der Eigenverbrauch sowie Schaltschwellen des beziehungsweise jedes Ladereglers (12) überprüfbar sind.

10. Vorrichtung nach Anspruch 9, **dadurch gekennzeichnet, daß** die Prüfmittel einen Temperatursensor (15) zur Ermittlung der Umgebungstemperatur umfassen.

## Claims

1. Apparatus for testing autonomous solar installations which as components comprise at least one respective photovoltaic solar generator (6), battery (7), charging regulator (12) and load (8), having connection means for connecting to the charging regulator (12) which is disconnected from the remaining components (6, 7, 8), having connection means for connecting to the or each solar generator (6), the or each battery (7) and the or each load (8) when the charging regulator(s) (12) is/are disconnected, having test means with which the components (6, 7, 8, 12) can be tested individually and in operationally typical wiring configurations with one another in order to ascertain parameters and statuses characteristic of the operativeness of the solar installation being tested, and having display means (18, 19, 20) for displaying the tested parameters and statuses, the connection means comprising plug connectors (3, 10) which are adapted to be inserted into associated socket connectors (4, 11) of a connecting bar (5), interruptible with a bridge (13), for the components (6, 7, 8, 12).

2. Apparatus according to claim 1, **characterised in that** the test means and display means are adapted to be connected via voltage transformers (162, 169) for the supply of external power to at least one battery (6) of the solar installation that is being tested.

3. Apparatus according to claim 1 or claim 2, **characterised in that** the test means comprise an adjustable reference voltage source (16, 181).

4. Apparatus according to any of claims 1 to 3, **characterised in that** in one setting (22) of the test means and display means a self-test to test for proper functioning can be carried out, in which self-test the operativeness of controls and circuit elements can be tested.

5. Apparatus according to any of claims 1 to 4, **characterised in that** in one setting (29) of the test means and display means a solar generator test can be carried out, in which the no-load voltage and short-circuit current of the or each solar generator (6) can be measured when the components comprising the battery (6), and battery and load(s) (8), respectively, are disconnected from the or each charging regulator (12).

6. Apparatus according to any of claims 1 to 5, **characterised in that** in one setting (34) of the test means and display means a battery test on the battery or batteries (7) can be carried out, in which the no-load voltage, the voltage when the solar generator(s) (6) is/are connected to system, and the charging current when the load(s) (8) is/are disconnected, can be measured.

7. Apparatus according to claim 5 or 6, **characterised in that** the test means comprise a reference solar generator (14) for detecting solar radiation.

8. Apparatus according to any of claims 1 to 7, **characterised in that** in one setting (36) of the test means and display means a load test can be carried out, in which the voltage and the current of the or each load (8) and the voltage of the or each battery (7) can be measured with the solar generator(s) (6) disconnected.

9. Apparatus according to any of claims 3 to 8, **characterised in that** in one setting (42) of the test means and display means for carrying out a charging regulator check with the components comprising the solar generator or generators (6), battery or batteries (7), and load or loads (8) disconnected, the adjustable reference voltage source (16, 181) can be switched to the or each charging regulator (12) and the intrinsic consumption and operating points of the or each charging regulator (12) can be tested.

10. Apparatus according to claim 9, **characterised in that** the test means comprise a temperature sensor (15) for ascertaining the ambient temperature.

## Revendications

1. Appareil de contrôle d'installations solaires autonomes qui comprennent au moins un de chaque composant suivant: un générateur solaire photovoltaïque (6), une batterie (7), un régulateur de charge (12) et une charge (8), l'appareil comportant des moyens de raccordement pour la connexion aux composants restants (6,7,8) après le découplage du régulateur de charge (12); des moyens de raccordement pour la connexion au ou à chaque générateur solaire (6), au ou à chaque batterie (7), au ou à chaque charge (12) avec le ou les régulateurs de charge découplés; des moyens de contrôle avec lesquels les composants (6, 7, 8, 12) isolés et les composants reliés ensemble en un circuit caractéristique au fonctionnement sont testés afin de déterminer les paramètres et les états relatifs au comportement de l'installation solaire contrôlée et des moyens d'affichage (18, 19, 20) des paramètres et des états ainsi déterminés; dans lequel les moyens de raccordement comprennent des rangées de fiches (3, 10) pouvant se connecter à des rangées d'embases (4, 11) reliées aux composants (6, 7, 8, 12), dont une embase comprend un support de raccordement (5) pouvant être interrompu par un pont (13).

2. Appareil selon la revendication 1, **caractérisé en ce que** les moyens de contrôle et les moyens d'affichage peuvent être alimentés par une source d'énergie externe à travers un convertisseur de tension (162, 169), ladite source est constituée par au moins une batterie (7) raccordée à l'installation solaire testée.

3. Appareil selon la revendication 1 ou 2, **caractérisé en ce que** les moyens de contrôle comportent une source de tension de référence ajustable (16, 181).

4. Appareil selon l'une des revendications 1 à 3, **caractérisé en ce que** dans une configuration (22), les moyens de contrôle et d'affichage permettent d'effectuer un self test, ledit self test permet de vérifier les fonctions de l'appareil ainsi que le bon fonctionnement des moyens de commande et de connexion.

5. Appareil selon l'une des revendications 1 à 4, **caractérisé en ce que** dans une configuration (29), les moyens de contrôle et d'affichage permettent d'effectuer un test de générateur solaire, ledit test permet de mesurer la tension à vide et le courant de court-circuit du ou de chaque générateur solaire (6), et ceci avec les composants tels que la ou les batteries (7) ou la ou les charges (8) découplés du ou de chaque régulateur de charge (12).

6. Appareil selon l'une des revendications 1 à 5, **caractérisé en ce que** dans une configuration (34), les moyens de contrôle et d'affichage permettent d'effectuer un test de batterie de la ou des batteries (7), ledit test permet de mesurer la tension à vide, la tension avec le ou les générateurs solaire (6) connectés et le courant de charge avec la ou les charges (8) découplées.

7. Appareil selon la revendication 5 ou 6, **caractérisé en ce que** les moyens de contrôle comprennent un générateur solaire de référence (14) permettant de déterminer le rayonnement solaire.

8. Appareil selon l'une des revendications 1 à 7, **caractérisé en ce que** dans une configuration (36), les moyens de contrôle et d'affichage permettent d'effectuer un test de charge, ledit test permet de mesurer la tension et le courant de la ou de chaque charge (8), et la tension de la ou de chaque batterie (7) avec le ou les générateurs solaire (6) découplés.

9. Appareil selon l'une des revendications 3 à 8, **caractérisé en ce que** dans une configuration (42), les moyens de contrôle et d'affichage permettent d'effectuer un test de régulateur de charge avec les composants tels que le ou les générateurs solaire (6), la ou les batteries (7), la ou les charges (8) découplés, ledit test nécessitant une source de tension de référence ajustable (16, 181) qui peut être connectée au ou à chaque régulateur de charge (12), permet de contrôler la consommation propre et les seuils d'enclenchement dudit ou desdits régulateurs de charge (12).

10. Appareil selon la revendication 9, **caractérisé en ce que** les moyens de contrôle comprennent une sonde de température (15) permettant de déterminer la température ambiante.
